Europäisches Patentamt

European Patent Office

Office européen des brevets

(19)

(11) Publication number: **0 274 591 B1**

(12) **EUROPEAN PATENT SPECIFICATION**

(45) Date of publication of patent specification: **15.04.92**  (51) Int. Cl.⁵: **H03L 7/08**, G11B 20/14

(21) Application number: **87116273.1**

(22) Date of filing: **05.11.87**

(54) **Phase lock circuit.**

(30) Priority: **12.11.86 IT 2230586**

(43) Date of publication of application:
**20.07.88 Bulletin 88/29**

(45) Publication of the grant of the patent:
**15.04.92 Bulletin 92/16**

(84) Designated Contracting States:
**DE FR GB**

(56) References cited:
**EP-A- 0 074 793**
**US-A- 3 944 940**
**US-A- 4 017 806**
**US-A- 4 246 545**
**US-A- 4 404 530**

**ELECTRONIC DESIGN, vol. 28, no. 18, 1st
September 1980, pages 168-169, Denville,
US; B. RUGGIRELLO "Wide effective margin
makes double-density recording reliable"**

(73) Proprietor: **BULL HN INFORMATION SYSTEMS
ITALIA S.p.A.
Via Martiri d'Italia 3
I-10014 Caluso (Torino)(IT)**

(72) Inventor: **Vitiello, Paolo
Via Verga 4
I-20017 Rho Milano(IT)**

Rank Xerox (UK) Business Services

## Description

The present invention relates to a phase lock circuit for the recognition of digital information read out from a movable magnetic media, particularly for disk units.

The magnetic recording technique commonly used in such units is the one known with the acronym MFM or modified frequency (or phase) modulation.

Along the tracks of the magnetic medium the binary information is recorded in sequence as magnetic transitions suitably located in ideal cells, which, in relationship to the speed of the medium as to a read/write head, are defined by a time interval or nominal duration.

For a rigid disk unit having interface ST506 the cell has a standardized nominal duration of 200 ns.

For a 5"1/4 flexible disk unit the cell has a nominal standard duration of 4 usec.

Recently 5"1/4 flexible disk units have been put on the market where the nominal cell duration is 2 usec.

In addition units for flexible disks having 8" diameter continue to be used in the market, both with nominal cell duration of 2 usec (recorded in MFM or double density) both with nominal cell duration of 4 usec (recorded in FM or single density).

In the MFM magnetic recording, information bits having a logic level 1 are recorded as a magnetic transition at the center of the cells and bits having a logic level 0 are recorded as lacks of transition in the cells.

In order to provide a timing signal even in presence of a "zeroes" sequence, subsequent "zero" cells are identified by a magnetic transition recorded at the boundary between the cells.

This transition is missing if a cell containing a bit "0" is preceded or followed by a cell containing a bit "1".

The FM coding method, contemplates the recording of a magnetic transition at each cell boundary and the presence of a transition in the middle of a cell in case of a "1" or no transition in the middle of a cell in case of a "0".

When the magnetic medium is read, each transition generates an electrical read pulse.

Therefore, in case of cells having nominal duration of 200 ns the read pulses nominally occur every 200,300,400 nsec; in case of cells having nominal period 2 usec, the read pulses nominally occur every 2,3,4 usec; in case of cells having nominal period 4 usec; the read pulses nominally occur every 4,6,8 usec; in case of cells having nominal period 4 usec (but with FM or single density coding) the read pulses nominally occur every 2 or 4 usec).

Owing to changes in the rotational speed of the medium an to the so called "peak shift" phenomena of the recorded magnetic pulses, the effective durations of the read out intervals largely differ from the nominal ones and give rise to a signal having variable phase and frequency which renders particularly difficult the discrimination among bits 0, 1 and timing pulses.

Phase lock circuits are used to perform such discrimination, that is circuits which, in response to the sequence of electrical pulses produced by the disk reading generate a timing signal having a variable frequency which follows the basic frequency of the read out pulse sequence but which ignore the significative modulation due to the magnetic recording process.

Such circuits must lock in a fast way to the read out data frequency, must be able to quickly follow the magnetic medium speed changes and must ignore, as already said, the phase changes due to the significative modulation.

An example of such circuits is provided by US-A-3,944,940.

In addition such circuits should, at a possible extent, operate at different working frequencies, in order to work with media recorded at different frequencies and coding modes.

Phase comparators, in form of integrated circuits have been recently put on the market.

By adding few external components to such phase comparators, it is possible to obtain discriminating phase lock circuits. However such circuits have limitations which prevents the design of reliable discriminators for a wide range of the magnetic medium speed variation, having fast locking and stability in operation.

The phase lock circuit which is the object of the present invention overcomes such limitations and is further capable of handling magnetic medium recorded in single or double density at different frequencies, for instance the standard frequencies of 5MHz, 500 KHz and 250 KHz.

The features and the advantages of the invention will appear more clearly from the following description of a preferred form of embodiment and from the enclosed drawing where:

- Figure 1 shows a phase lock circuit of the prior art.
- Figure 2 shows in timing diagram the signal level at some points of the circuit of Fig. 1.
- Figure 3 shows in Bode diagram, the frequency response of the low-pass filter used in the circuit of Fig. 1.
- Figure 4 shows in Bode diagram the open loop frequency response of the circuit of Fig. 1.
- Figure 5 shows a first preferred form of embodiment of phase lock circuit according to the invention.

- Figure 6 shows in Bode diagram the frequency response of the low-pass filter used in the circuit of Fig. 5.
- Figure 7 shows in Bode diagram, the open loop frequency response of the circuit of Fig. 5
- Figure 8 shows in timing diagram, the signals present at some points of the circuit of Fig. 5.
- Figure 9 shows in diagram form the response of the Fig. 5 circuit at operating conditions around the nominal working frequency.
- Figure 10 shows a second preferred form of embodiment of the phase lock circuit according to the invention.

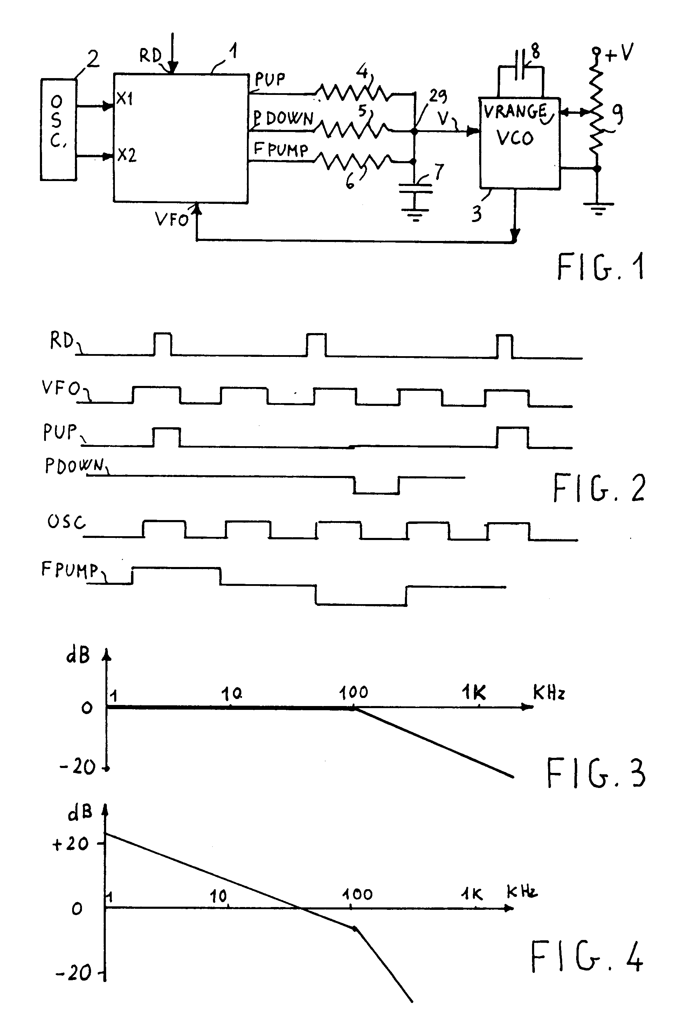

Figure 1 shows a phase lock circuit known in the art, whose operation is easily understood with reference to the timing diagram of Figure 2. Such circuit makes use, as a basic component, of a phase comparator integrated circuit 1, which is produced by the firm Signetics and is marketed with code SCB68459.

The integrated circuit has two inputs X1, X2, connected to the outputs of an oscillator 2.

The oscillator 2 provides in output a square wave timing signal having a frequency twice the basic frequency of the read out information stream, (Signal OSC, Figure 2).

Therefore in case of diskettes recorded in MFM at 500 KHz this frequency is 1 MHz.

Component 1 receives at input RD the read signal pulses produced by a read head (Diagram RD, Fig. 2).

Such pulses are distant each other (in time) about2, 3 or 4 usec.

Component 1 receives further at input VF0 a square wave periodic signal (VF0, Fig. 2) produced by a voltage controlled oscillator, consisting for instance in the integrated circuit manufactured by the firm Texas Instruments with code SN74L5629.

Signal VF0 has a variable frequency spanning around the frequency of oscillator 2.

Component 1 has three outputs P UP, P DOWN, F PUMP and provides in output three omologous signals (Figure 2) having the following features:

If signal RD rises when signal VFO is 1, the P UP output, normally at high impedance, is connected to a positive voltage source (+5V) until the fall to 0 of VF0, thus providing a positive voltage pulse (Diagram P UP).

If signal RD rises when VF0 = 0, the output P DOWN, normally at high impedance, is connected to ground with the next following drop to 0 of VF0 and is held to 0 for half a period of signal VF0 (Diagram P DOWN).

Eventually the output F PUMP is periodically connected to a positive voltage source ( + 5V) for a whole period of signal VF0, held at high impedance for at least the next following half period of signal VF0, connected to ground for a whole period duration of signal OSC, and again held at high impedance till the beginning of the next following period of VFO, at which time it is again connected to the positive voltage source.

It may be immediately noted that, if RD pulses are synchronous with the falling edge of VF0, the two outputs P UP, P DOWN are kept in high impedence state and no output signal is produced.

If the rising edge of RD is in advance of the falling edge of VF0, the output P UP raises to + 5V for a time interval proportional to the phase lead.

Signal P UP is therefore a phase error signal whose duration is proportional to the lead error.

Likewise, if the rising edge of RD is lagging as to the falling edge of VF0, the output P DOWN drops to 0 for a time interval which is nearly constant and equal to half the VF0 period.

Signal P DOWN is therefore a lag error signal which is not error proportional.

Likewise the signal at output F PUMP is proportional, in average, to the error difference between the frequency of the two signals VF0 and OSC.

Signals P UP, P DOWN, F PUMP are fed to an integrating network comprising three resistors 4,5,6 and a capacitor 7.

The three resistors have each a terminal connected to output P UP, P DOWN, F PUMP respectively, the second terminal in common (node 29) and connected to an armature of capacitor 7. The other armature is connected to ground.

It is clear that signal P UP tends to charge capacitor 7, whilst signal P DOWN tend to discharge it.

Signal F PUMP tends in the average to charge capacitor 7 if the period of VF0 is greater than the OSC period and to discharge capacitor 7 in the opposite case.

The variable charge voltage V of capacitor 7 is applied to a control input of oscillator 3, which modifies its oscillating frequency as a function of such signal, in a span around a preestablished frequency defined by external parameters consisting in a capacitor 8, connected to suitable inputs and a voltage VRANGE applied to a suitable input and obtained from a voltage divider 9.

The described regulation circuit operates by changing the frequency of signal VF0 in a way such that the rising edge of read signal is the possible closer and coincident with the falling edge of signal VF0.

Signal VF0 may therefore be used by a control unit, not shown, to generate pulses, derived from the read pulses but synchronized with signal VF0, which may be discriminated as data pulses or timing pulses.

The described circuit has the following limitations:

The manufacturer of component 1 recommends for resistors 4,5,6, the value of 1 K, 10 K and 100 K respectively, and for capacitor 7 a value C such that the time constant T of the low-pass filter comprised of resistor 4 and capacitor 7 be 5 times the nominal occurrence period of the read signal.

For data recorded at 500 KHz (2 usec period) the time constant of the circuit is therefore 10 usec and give rise to a frequency response diagram of the type shown in Fig. 3.

The diagram shows that the lows-pass filter has a constant gain till the cut off frequency of 100 KHz and a 20 dB per decade attenuation from such frequency onward.

The low-pass filter is only one of the blocks which compose the feedback control system.

The other blocks are the phase comparator 1 and the VC0 3.

The phase comparator is characterized by a constant gain Kd for the whole frequency range of interest whilst the VC0 3 is intrinsically equivalent to a pure integrator with a transfer function which in syntetic form is expressed by the relation

$$K(S) VCO = \frac{Ko}{S}$$

where S is the Laplace variable and Ko the block gain at zero frequency.

The open loop transfer function of the whole system is therefore

$$K(s) = \frac{Kd \cdot F(s) \cdot Ko}{S}$$

where F(s) is the transfer function of the low pass filter.

Since the VC0 gain has a pole at zero frequency and the low pass filter has a pole at frequency 1/T, where T is the time constant of the filter, the transfer function has two poles.

This results, when displayed as Bode diagram, in an attenuation diagram having 20 dB per decade slope in the frequency range from zero to 100 KHz and a 40 dB per decade slope from 100 HHz onward.

This feature may appear advantageous because it reduces the sensitivity of the system to sudden phase changes having a frequency greater than 100 KHz, but the trade off is a limitation of the gain which may be established for the control loop.

In fact, for the system stability, it is required as a canon, that the attenuation curve crosses the line corresponding to a 0dB gain with a slope of 20 dB per decade.

This results in the adoption of a limited gain in the range from 1 to 2 KHz, which gain is unadequate to provide a fast phase lock and a prompt response to speed changes of the magnetic media (which changes mostly occur in the range from 1 to 2 KHz), whilst in the range from 10 to 100 KHz the gain is greater than 1 with possible excitation of oscillations, however damped.

Further the current drained at the VC03 input causes, even in static conditions, a regulation offset that is a constant delay of signal VF0 as to signal RD.

Similar considerations are true for the control loop which makes use of signal P DOWN as a control signal.

In this case the circumstance that the correction signal is not proportional to the error results in a gain inversely variable with the error amount and renders even more uncertain the system behaviour.

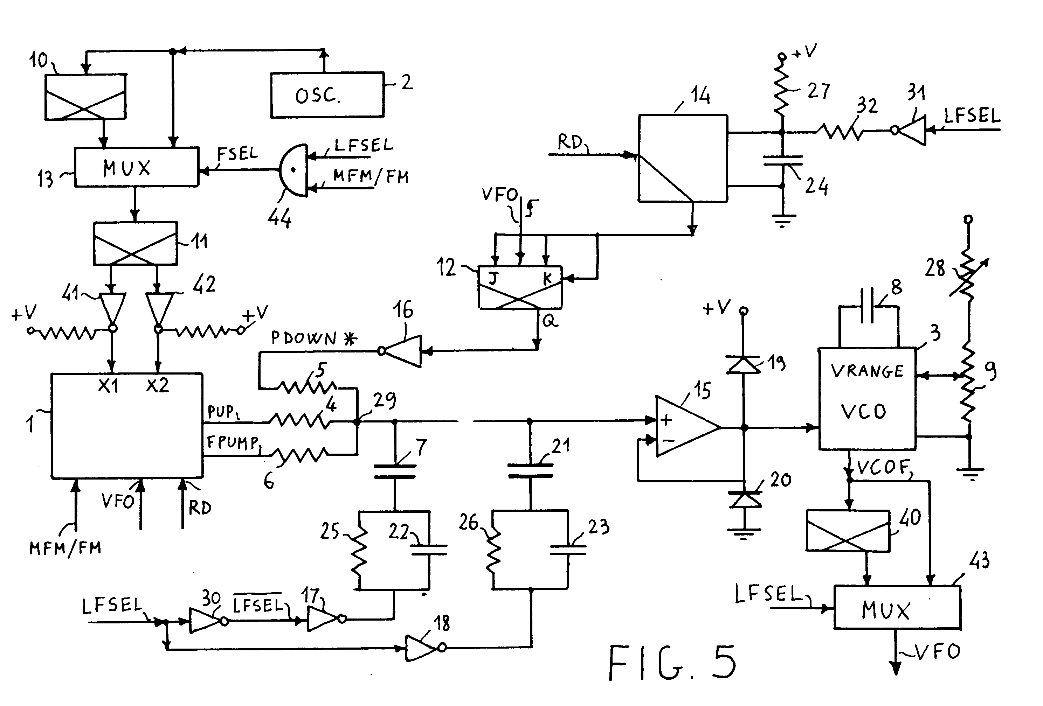

Figure 5 shows a preferred form of embodiment for a phase lock circuit in accordance with the invention.

In Figure 5 several of the components are the same as in Figure 1 and are referenced with the same number.

In addition to such components the phase lock circuit of Fig. 5 comprises four JK flip flop 10,11,12,40 two ways, two inputs multiplexers 13,43, a univibrator 14, an operational MOSFET amplifer 15, six open collector inverters 16,17,18,31,41,42, two diodes 19,20, four capacitors 21,22,23,24, four resistors 25,26,27,32, a positive temperature coefficient PCT resistor 28, an inverter 30 and a two inputs AND gate 44.

The oscillator 2 provides in this case a square wave signal having a 2 MHz frequency.

The oscillator 2 output is connected to the clock input of flip flop 10 arranged to operate as a frequency divider.

Therefore a square wave signal having 1 MHz frequency is available at it direct output.

The flip flop 10 output is connected to an input of multiplexer 13.

A second input of multiplexer 13 is directly connected to the oscillator 2 output.

A signal FSEL applied to the control input of multiplexer 13 selects which of the inputs signals is transferred to the multiplexer output.

When FSEL = 1 the multiplexer 13 transfers to its output the signal having frequency of 1 MHz, and when FSEL = 0 the signal having frequency of 2 MHz is output.

The output signal from multiplexer 13 is applied to the clock input of flip flop 11, providing a further frequency division.

The outputs of flip flop 11 are connected, through the open collector inverters 41, 42, to the inputs X1, X2 of the integrated circuit 1 (phase comparator).

The outputs of the two inverters 41,42 are obviously connected, through a pull up resistor, to a voltage source +V.

Therefore, depending on the level of signal FSEL a signal having a frequency of 500 KHz or 1MHz is selectively received at inputs x1,x2.

The arrangement is provided so that the circuit of Fig. 5 may operate both with magnetic medium recorded at 250 KHz in MFM mode both with magnetic medium recorded at 500 KHz, in MFM mode depending on external control signal FSEL.

The integrated component 1 is further provided with a control input PRESCALEN, receiving a signal MFM/FM which control the circuit to operate, in addition to the MFM mode, with magnetic medium recorded in FM mode (signal MFM/FM = 0) at a frequency equal to 1/4 of the received clock signal frequency.

Therefore in order to allow the operation in FM mode, the signal FSEL is the logical AND provided by AND gate 44, of the two signals MFM/FM and LFSEL the last being indicative, when at logical level 1 of a working frequency of 250 KHz.

This arrangement is not adequate.

In fact there is the need to adapt the frequency response or regulation diagram of the system to two different working conditions.

To this purpose, capacitor 7, instead of having a terminal permanently ground connected, has a terminal connected to the open collector output of NOT 17 through resistor 25 and parallel connected capacitor 22.

A second capacitor 21 is connected to node 29 on one side, and to the output of NOT 18 through a resistor 26 and a parallel connected capacitor 23.

The function of resistors 25,26 and capacitors 22,23 will be explained in the following.

NOT gate 17 has the input connected to the output of NOT gate 30.

Both NOT 30 and 18 receive as input the signal LFSEL.

Therefore when LFSEL = 1, capacitor 7 is isolated from ground and capacitor 21 is virtually ground connected (through resistor 21) whilst, when LFSEL = 0, capacitor 21 is isolated from ground and capacitor 7 (through resistor 25) is virtually ground connected.

By a suitable choice of the two capacitors 7,21 value, two different time constants may be defined for the integrating network, respectively for operation at a nominal frequency of 500 KHz (LFSEL = 0, capacitor 7 ground connected) and at a nominal frequency of 250 KHz (LFSEL = 1, capacitor 21 ground connected).

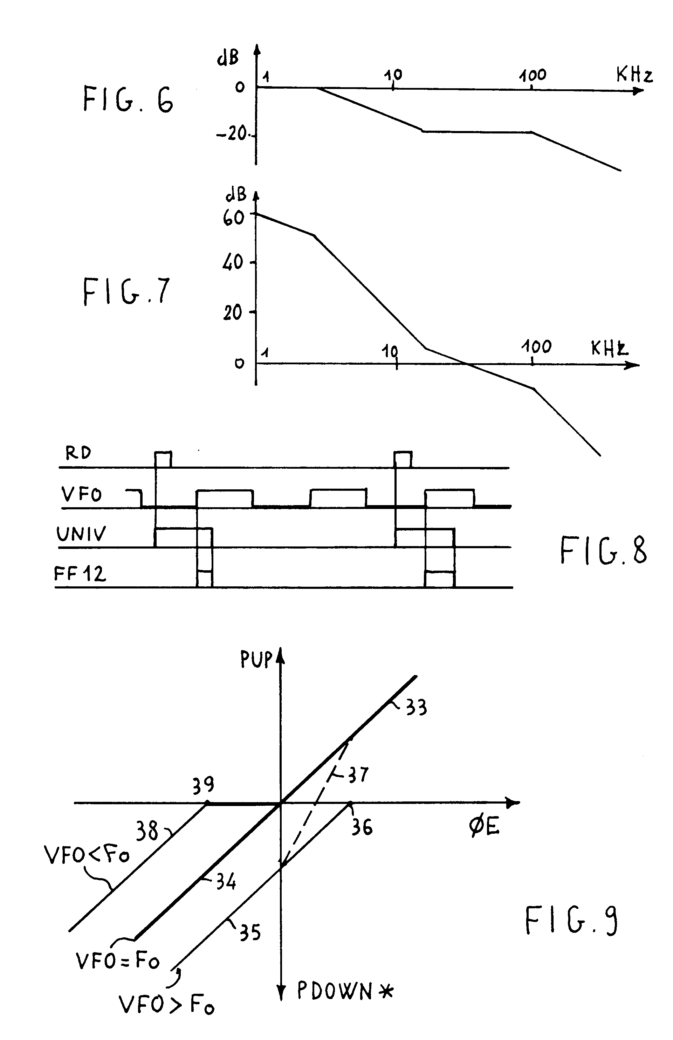

The addition of a resistor such as 25 or 26 and a parallel connected capacitor such as 22 or 23 between an armature of capacitor 7,21 respectively and ground provides an integrating network or low pass filter having two poles and a zero, with an attenuation diagram of the type shown in Fig. 6.

Such diagram has two steps, whose position on the abscissa (the frequency axis) is determined by the value of the components.

It results that the open loop transfer function of the whole control system is represented by a Bode diagram of the type shown in figure 7.

A frequency response diagram is obtained, which is characterized by an high gain at low frequencies, and the crossing of the O dB gain line occurs with a slope of 20 dB per decad, at a frequency which may be suitably set at about 30 and 60 KHz, respectively for operation of the circuit at 250 and 500 KHz.

A further element which distinguishes the circuit of Fig. 5 from the circuits known in the art is that resistor 5 is not connected to the output P DOWN of element 1.

Instead, resistor 5 is connected to the open collector output of NOT 16, whose input is connected to the Q output of JK flip flop 12. Flip flop 12 is triggered by signal VFO received at the clock input.

The J, K inputs and the reset input R of flip flop 12 are connected to the output of univibrator 14, consisting for instance in the integrated circuit 74LS123.

Univibrator 14 is triggered by the rising edge of signal RD received as input and produces in output a pulse at logical/electrical level 1.

The pulse duration is established by the time constant of an external RC circuit, consisting in resistor 27, capacitor 24 and resistor 32.

A terminal of resistor 27 is connected to the power voltage source +V. The other terminal, together with a first terminal of resistor 32 is connected to an input of univibrator 14 and to an armature of capacitor 24. The other armature is ground connected.

The second terminal of resistor 32 is connected to the open collector output of NOT 31, which receives in input signal LFSEL.

The values of resistors 27,32 and capacitor 24 are so selected that the duration of the pulse generated by univibrator 14 is equal to half the period of the frequency received by integrated element 1 at inputs X1,X2, that is 0,5 usec when LFSEL = 0 and 1 usec when LFSEL = 1.

The operation of the control system composed by the chain univibrator 14, flip flop 12, NOT 16 and resistor 5 may be easily understood with reference to the timing diagram of figure 8.

At each read pulse RD a pulse UNIV is generated which has a duration very close to half the period of signal VF0.

In fact the frequency of signal VF0, in normal operating conditions, coincides with or slighty departs (±5%) from the nominal working frequency (The frequency F0 received at inputs X1, X2 of circuit 1).

When the read pulses RD are leading as to the fall edge of signal VF0, the pulses UNIV ends before the rising of VF0 signal from 0 to 1.

Therefore the rising edge of signal VFO does not have any effect on flip flop 12 which is held in reset by signal UNIV = 0 present at the reset input.

Thus the NOT 16 output is ground isolated together with terminal of resistor 5.

On the contrary; when the read pulses RD are lagging as to the falling edge of VF0, the UNIV pulses end when signal VF0 has already risen from 0 to 1.

Therefore the raising edge of signal VF0 has the effect to set flip flop 12 (Diagram FF12) which remains set till the end of pulse UNIV.

This has the effect of termporarily ground connecting resistor 5 or, which is the same, of applying to resistor 5 an error signal having electrical level 0, which signal has a duration substantially proportional to the lag of pulses RD.

This signal tends to discharge capacitor 7 or 21 with a corresponding and proportional correcting effect.

This signal is referenced in the following as PDOWN* to distinguish it from signal PDOWN generated by integrated element 1.

The control performances of the system are therefore greatly enhanced as to those of the Fig. 1 circuit.

A further inventive aspect consists in the fact that node 29 of the integrating network is not connected to the input of controlled oscillator 3, but to the non inverting output of a MOSFET operational amplifier 15, for instance the one marketed by NATIONAL firm with code LF 347.

The input impedance of such amplifier is virtually infinite.

Therefore the "regulation offset" and instability intrinsic in the control circuit of the prior art are avoided.

The output of amplifier 15 is connected to the control input of controlled oscillator VCO 3.

Two diodes 19,20, connected between the output of amplifier 15 and the power voltage source + V or ground respectively, guarantees that the signal in output from amplifier 15 remains in the range 0, + V.

The inverting input of the amplifier is connected to the output so that it works as a voltage follower with unit gain.

A further improvement consists in the use of a positive temperature coefficient PCT thermistor 28 series connected between the voltage source + V and voltage divider 9.

In fact, the controlled oscillator 3 is affected by thermal drift.

In other words, the generated frquency, for a given control voltage applied in input and for a given capacity and range voltage VRANGE which define the operating range, varies in dependence of the temperature and tends to decrease as the temperature increases.

The use of PCT 28 allows to change the range voltage as an inverse function of the temperature, thus compensating the effects of temperature drift.

A further inventive aspect consists in the fact that, even if the described circuit is provided to operate which media recorded at different frequences (250 KHz and 500 KHz) the controlled oscillator VCO 3 is caused to operate in both cases, around the same working point, that is around the 1 MHz frequency.

Signal VFC0 in output from oscillator 3 is applied to an input of multiplexer 43 and to the clock input of flip flop 40, operating as a frequency divider.

The direct output Q of flip flop 40 is connected to a second input of multiplexer 43 which is controlled by signal LFSEL.

When LFSEL = 1, it indicates that the circuit must operate with data recorded at a frequency of 250 KHZ;

Therefore, when LFSEL = 1 multiplexer 43 transfers in output the signal having a frequency of about 500 KHz provided by flip flop 40.

When LFSEL = 0 the multiplexer transfer in output the signal having a frequency of about 1MHz, directly generated by oscillator 3.

In other words a signal is present at the output of multiplexer 43 which has the frequency required by different working conditions even if voltage controlled oscillator 3 always operate around a single working point.

This is very important because the working point may be precisely set with a single trimming operation and the use of a single trimming element (voltage divider 9).

The phase lock circuit described with reference to Figure 5 provides excellent performances by far greater than those provided by phase lock circuits known in the art and is particularly suitable when speed variation of the magnetic media are contained in a reasonable range (± 5%) as to the nominal speed.

It is however possible to extend its performances for use in magnetic recording units where the speed of the magnetic media is possibly affected by broader changes.

In fact it has beeen said that the duration of signal PDOWN is substantially proportional to the phase lag of the read pulses RD as to signal VF0.

This is strictly true when the frequency of signal VF0 is equal to the nominal working frequency F0 of the system (that is the oscillator 2 frequency divided by 2 or 4 depending on the recording density).

Practically the frequency of signal FV0 departs from such value in order to follows the changes in the magnetic media speed.

Since the period of the pulses generated by univibrator 14 has a fixed duration equal to 1/2 F0 the proportionality relation is not rigorously followed when the frequency of signal VF0 differs from F0.

When the frequency of VF0 is greater than the one of F0, there is an overlapping in time, between pulses UNIV produced by univibrator 14 and the positive half waves of signal VF0 even if the read pulses RD are phase leading as to signal VF0.

In this case there is a phase lead range in which signals PUP and PDOWN are jointly produced with opposite effect and partially neutralize each other.

When the frequency of VF0 is lesser than the one of F0 there is a phase lag range for signal RD in which no PDOWN* signal si generated.

In other words there is a dead band in which the control system is unsensitive.

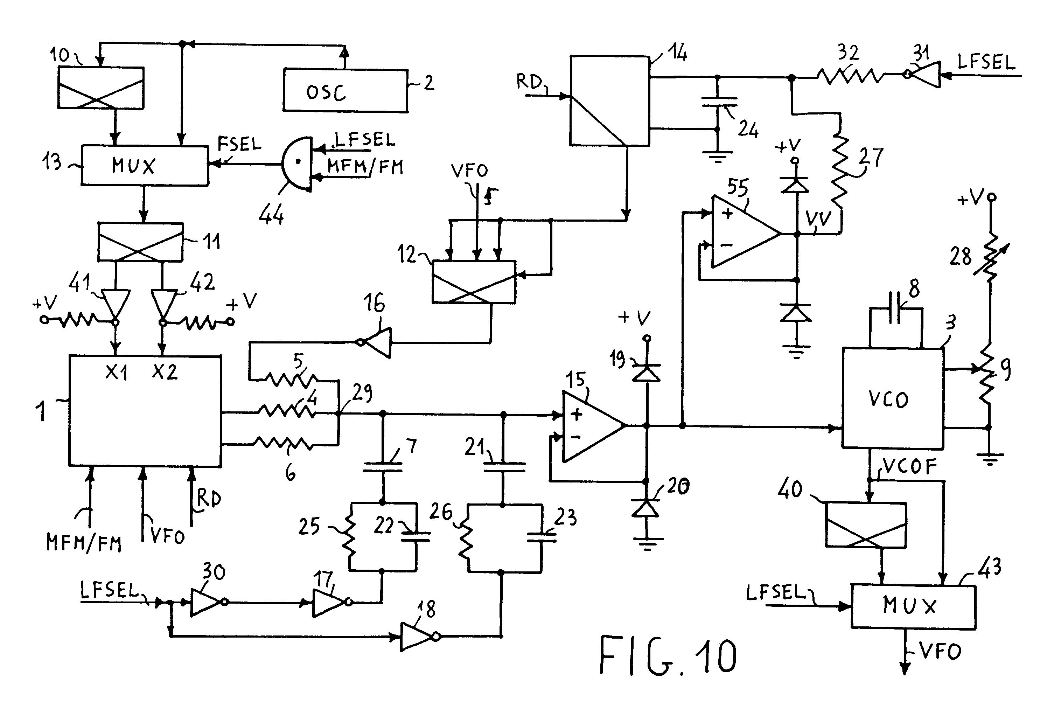

Figure 9 shows in diagram form the response of the phase error measurement circuits for the three different depicted above.

The phase errors ØE of the read pulses RD as to VF0 are reported in abscissa and the corresponding duration of the error pulses PUP, PDOWN which are generated is reported on the ordinate.

Since the correcting function of signals PDOWN is negative, the corresponding duration is reported on the negative axis of the ordinates.

The solid line 33 shows the proportionality relation existing between positive phase errors and duration of the corresponding error signals PUP.

The solid line 34 shows the proportionally relation existing between negative phase errors and duration of the corresponding signals PDOWN* when FC0 has the same frequency of F0.

The solid line 35 shows the relation between negative phase error and duration of the corresponding error signal when VF0 frequency is greater than F0 frequency.

A shift or offset of line 35 as to line 34 may be noted.

This offset results, at control level in a working point offset relative to the desired one.

In other words if the RD pulses are lagging, the error signal PDOWN* tends to correct the VF0 frequency and to decrease it until the RD pulses are leading of a certain amount identified by point 36 of the diagram rather than being exactly phased.

More precisely in the error range comprised between 0 and point 36 there is an overlapping of corrective actions so that the effective regulation diagram results to be the one shown by dotted line 37.

The solid line 38 shows the relation existing between negative phase errors and the duration of the corresponding error signal when VF0 frequency is lesser than the one of F0.

Even in this case an offset may be noted which at control level results in an offset of the working point as to the desired one: in other words if the RD pulses are logging, the error signal PDOWN* tends to correct the VF0 frequency and to increase it until the phase error is the one defined by point 39.

At this point the corrective action ceases.

Therefore the system is insensitive to negative phase errors comprised between 0 and the value identified by point 39.

This limitation may be overcome by the phase circuit shown in Fig. 10.

The circuit of figure 10 differs from the one of Figure 5 in some details only.

Therefore the corresponding elements which perform the same function are referenced by the same numeral.

The substantive difference between the circuit of Fig. 9 and the one of Fig. 5 is that resistor 27, which defines the duration of the pulses UNIV generated by univibrator 14, rather than being connected to voltage source +V is connected to a variable voltage VV.

This voltage VV is "de facto" the same voltage inputted to oscillator 3 and is obtained from an operational MOSFET amplifier 55 identical to amplifier 15 and having the same "voltage follower" function.

Being the oscillator VC03 response substantially linear and proportional (in other words VCOF:VV), the changes of VV are proportionally equal to the changes of VF0 and VCOF.

The duration of the UNIV pulses, generated by univibrator 14 depends on the time required by capacitor 24 to be charged at a prestablished threshold level VS.

This time is clearly a function of the time constant of the RC circuit comprised of resistors 27,32 and capacitor 24, but with reasonable approximation is also inversely proportional to the voltage feeding the RC network at least so long as the leeding voltage is reasonably greater than the threshold voltage VS ($VV > 1,5 VS$)

By changing voltage VV it is possible to change the duration of the UNIV pulses in the same percent measure of the changes in the VF0 period.

As an ultimate result the duration of the UNIV pulses may be rendered equal to half the VF0 period rather than 1/2 F0 period.

The condition (VV ≥ 1,5 V5) may be easily satisfied considering that the integrated circuit 74S123 has a threshold value of about 2 V and that the integrated circuit 74LS624 accepts a frequency control voltage ranging from 0 to 5V.

Therefore a working point may be established for VC0 3, for which an output frequency of signal VCOF of 1 MHz corresponds to a control voltage of 4V.

As an alternative, the operational amplifier 55 may be used as a "voltage follower plus offset" and may apply to resistor 27 a voltage equal to the voltage controlling VC03 plus a fixed quantity. In this case the working point for VC03 may be set at range center so that an output VCOF frequency of 1 MHz corresponds to a control voltage of 2,5 V.

It is clear that several other changes may be provided to the phase lock circuits of Fig. 5 and 9 without departing from the scope of the invention.

For instance the NOT elements 16,17,18,31 may be substituted with equivalent components such as open collector NORs, open collector NAND etc., by connecting the inputs to suitable level signal sources.

Likewise the time constant of RC network coupled to univibrator 14 may be changed, rather than by selective ground connection of resistor 32 by providing as a substitute for resistor 32, a capacitor which is selectively connected and disconnected.

It is further clear that if a phase lock circuit is desired, which has to operate at a single frequency, several of the components such as flip flops 10,11,40, multiplexers 13,43 capacitors 7,22 resistors 25,32 and gates 17,18,30,31,44 may be omitted.

Although the description refers to the handling of disks recorded at a frequency of 250 KHz and 500 KHz it is clear that the same implementation concepts may be used for phase lock circuits working at frequences other than the indicated ones, for instance rigid disks tipically working at a 5 MHz frequency, and "streamer tapes" recently put in the market.

For description completeness the value of some parameters, useful for obtaining the desired performances, is given.

Value of resistor 4,5,6 : 5,6 K ;10 K ;100 K respectively.

Value of resistors 25,26: 1 K and 1,5 K respectively.

Value of capacitors 7,21 : 22 nF, 47 nF respectively.

Value of capacitors 22,23 : 1500 pF.

## Claims

1. Phase lock circuit comprising
   - an oscillator (2,11) for generating a working frequency signal (OSC) twice the nominal recording frequency of data recorded on a magnetic medium,
   - a phase comparator(1) having a first input (RD) for receiving periodic reading pulses of said medium, a second input (X1,X2) for receiving said working frequency (OSC) and a third input for receiving a variable frequency signal (VFO), said phase comparator generating a pulsed lead phase error signal (PUP) consisting in voltage pulses having width equal to the lead between the rising edge of each of said periodic reading pulses and a reference edge of said variable frequency signal, said phase comparator further generating a pulsed frequency error signal (FPUMP) whose average amplitude is proportional to the frequency error of said variable frequency signal (VFO) relative to said working frequency signal (OSC),
   - a variable frequency oscillator (3) for generating said variable frequency signal (VFO) at a frequency proportional to a voltage received at an input, characterised in that it further comprises
   - circuit means (12,14) for generating a pulsed lag phase error signal (FF12) consisting in voltage pulses having width substantially equal to the lag between said rising edge of each of said periodic reading pulses and a reference edge of said VFO signal,
   - an integrating filter network having a node (29), a first resistor(4) having one terminal connected to said node(29) and the other terminal connected to said phase comparator(1) and receiving said lead phase error signal (PUP), a second resistor(6) having one terminal connected to said node(29) and the other terminal connected to said phase comparator(1) and receiving said frequency error signal (FPUMP), a third resistor(5) having one terminal connected to said node(29) and the other terminal connected to switching means(16), said switching means being controlled by said pulsed lag phase error signal(FF12) to ground said other terminal for the duration of said lag phase error signal, a first capacitor (7) having a terminal connected to said node (29) and the other terminal ground-connected through a first compensating network comprising a parallel connected compensating resistor (25) and compensating capacitor (22),

- a high input impedance voltage follower (15) having an input connected to said node (29) and the output connected to said input of said variable frequency oscillator,

and in that

said variable frequency signal(VFO) being input to said third input of said phase comparator (1) and to an input of said circuit means (12,14).

2. Phase lock circuit as claimed in claim 1 wherein said oscillator (2,11) comprises a frequency divider (10) and a multiplexer (13) controlled by at least one control signal (LFSEL) to provide to said phase comparator (1), selectively, one of two working frequencies, and wherein said integrating network comprises a second capacitor (21) having a terminal connected to said node (29) and the other terminal connected to ground through a second compensating network comprising a compensating resistor (26) and an compensating capacitor (23) and first logic control means (17,18,30) controlled by said control signal (LFSEL) to disconnect from ground, in mutually exclusive way, said first or second capacitor, and wherein said variable frequency oscillator (3) comprises a frequency divider (40) and a multiplexer (43), controlled by said control signal (LFSEL) for generating at least two variable frequency signals, one having frequency twice of the other, and for inputing to said phase comparator and to said circuit means, one of said two variable frequency signals, selectively.

3. Phase lock circuit as claimed in claim 2 wherein said circuit means (12,14) comprises a univibrator (14), triggered by the rising edge of said periodical reading pulses for generating pulses having duration established by an external integrating network (24,27,32) having at least two time constants, selectable in mutually exclusive way by said control signal (LESEL) and second logical means (12) receiving in input the pulses generated by said univibrator and said variable frequency signal VF0 in output from said variable frequency oscillator (3) for generating said pulsed lag phase error signal (FF12).

4. Phase lock circuit as claimed in claim 3 wherein said external integrating network (24,27,32) is fed by a voltage signal (VV) variable substantially as the voltage at said node (29).

5. Phase lock circuit as claimed in claim 3 wherein said variable frequency oscillator (3) for generating in mutually exclusive way at least two variable frequency signals, comprises an external capacitor (8) and an external trimming resistor (9) defining a single working range independently of the variable frequency signal selected in output from said variable frequency oscillator.

6. Phase lock circuit as claimed in claim 5 wherein said variable frequency oscillator comprises a PCT resistor (28) for the stabilization in temperature of said working range.

**Revendications**

1. Circuit à verrouillage de phase comprenant :
   - un oscillateur (2, 11) pour générer un signal de fréquence de travail (OSC) double de la fréquence d'enregistrement nominale de données enregistrées sur un support magnétique;
   - un comparateur de phase (1) ayant une première entrée (RD) pour recevoir des impulsions de lecture périodiques dudit support, une deuxième entrée (X1, X2) pour recevoir ladite fréquence de travail (OSC) et une troisième entrée pour recevoir un signal à fréquence variable (VFO), ledit comparateur de phase générant un signal impulsionnel d'erreur de phase en avance (PUP) consistant en impulsions de tension ayant une largeur égale à l'avance entre le front de montée de chacune desdites impulsions de lecture périodiques et un front de référence dudit signal à fréquence variable, ledit comparateur de phase générant de plus un signal impulsionnel d'erreur de fréquence (FPUMP) dont l'amplitude moyenne est proportionnelle à l'erreur de fréquence dudit signal à fréquence variable (VFO) par rapport audit signal de fréquence de travail (OSC);
   - un oscillateur à fréquence variable (3) pour générer ledit signal à fréquence variable (VFO) à une fréquence proportionnelle à une tension reçue à une entrée;

   caractérisé en ce qu'il comprend de plus :
   - des moyens de circuit (12, 14) pour générer un signal impulsionnel d'erreur de phase en retard (FF12) consistant en impulsions de tension ayant une largeur sensiblement égale au retard entre ledit front de montée de chacune desdites impulsions de lecture périodiques et un front de référence dudit signal VFO;

- un circuit filtre d'intégration ayant un noeud (29), une première résistance (4) ayant une borne connectée audit noeud (29) et l'autre borne connectée audit comparateur de phase (1) et recevant ledit signal d'erreur de phase en avance (PUP), une deuxième résistance (6) ayant une borne connectée audit noeud (29) et l'autre borne connectée audit comparateur de phase (1) et recevant ledit signal d'erreur de fréquence (FPUMP), une troisième résistance (5) ayant une borne connectée audit noeud (29) et l'autre borne connectée à des moyens de commutation (16), lesdits moyens de commutation étant commandés par ledit signal impulsionnel d'erreur de phase en retard (FF12) pour relier à la masse ladite autre borne pendant la durée dudit signal d'erreur de phase en retard, un premier condensateur (7) ayant une borne connectée audit noeud (29) et l'autre borne connectée à la masse par l'intermédiaire d'un premier réseau de compensation comprerant une résistance de compensation (25) et un condensateur de compensation (22) connectés en parallèle;

- un suiveur de tension à impédance d'entrée élevée (15) ayant une entrée connectée audit noeud (29) et la sortie connectée à ladite entrée dudit oscillateur à fréquence variable;

et en ce que :

- ledit signal à fréquence variable (VFO) est entré sur ladite troisième entrée dudit comparateur de phase (1) et sur une entrée desdits moyens de circuit (12, 14).

2. Circuit à verrouillage de phase selon la revendication 1, dans lequel ledit oscillateur (2, 11) comprend un diviseur de fréquence (10) et un multiplexeur (13) commandé par au moins un signal de commande (LFSEL) pour fournir audit comparateur de phase (1), sélectivement, une parmi deux fréquences de travail, et dans lequel ledit circuit d'intégration comprend un deuxième condensateur (21) ayant une borne connectée audit noeud (29) et l'autre borne connectée à la masse par l'intermédiaire d'un deuxième réseau de compensation comprenant une résistance de compensation (26) et un condensateur de compensation (23) et des premiers moyens de commande logique (17, 18, 30) commandés par ledit signal de commande (LFSEL) pour déconnecter de la masse, de manière mutuellement exclusive, ledit premier ou deuxième condensateur, et dans lequel ledit oscillateur à fréquence variable (3) comprend un diviseur de fréquence (40) et un multiplexeur (43), commandé par ledit signal de commande (LFSEL) pour générer au moins deux signaux à fréquences variables, l'un ayant une fréquence double de l'autre, et pour entrer dans ledit comparateur de phase et dans lesdits moyens de circuit l'un desdits deux signaux à fréquences variables, sélectivement.

3. Circuit à verrouillage de phase selon la revendication 2, dans lequel lesdits moyens de circuit (12, 14) comprennent un générateur d'impulsions crénelées (14), déclenché par le front de montée desdites impulsions de lecture périodiques, pour générer des impulsions ayant une durée établie par un circuit d'intégration externe (24, 27,32) ayant au moins deux constantes de temps pouvant être choisies de manière mutuellement exclusive par ledit signal de commande (LFSEL), et des deuxièmes moyens logiques (12) recevant en entrée les impulsions générées par ledit générateur d'impulsions crénelées et ledit signal à fréquence variable (VFO) en sortie dudit oscillateur à fréquence variable (3) pour générer ledit signal impulsionnel d'erreur de phase en retard (FF12).

4. Circuit à verrouillage de phase selon la revendication 3, dans lequel ledit circuit d'intégration externe (24, 27, 32) est alimenté par un signal de tension (VV) sensiblement variable comme la tension audit noeud (29).

5. Circuit à verrouillage de phase selon la revendication 3, dans lequel ledit oscillateur à fréquence variable (3) pour générer de manière mutuellement exclusive au moins deux signaux à fréquences variables comprend un condensateur externe (8) et une résistance ajustable externe (9) définissant un domaine de travail unique indépendamment du signal à fréquence variable choisi en sortie dudit oscillateur à fréquence variable.

6. Circuit à verrouillage de phase selon la revendication 5, dans lequel ledit oscillateur à fréquence variable comprend une varistance C T.P. (28) pour la stabilisation en température dudit domaine de travail.

**Patentansprüche**

1. Verriegelungsschaltkreis mit

   - einem Oszillator (2, 11) zur Erzeugung eines Arbeitsfrequenzsignals (OSC) mit doppelter Frequenz im Vergleich zur Nennaufzeichnungsfrequenz von Daten auf einen magnetischen Träger;
   - einer Phasenvergleichsschaltung (1) mit einem ersten Eingang (RD) zum Empfang periodischer Leseimpulse für den Träger, einem zweiten Eingang (X1, X2) zum Empfang der Arbeitsfrequenz (OSC) und einem dritten Eingang zum Empfang eines Signals variabler Frequenz (VFO), wobei die Phasenvergleichsschaltung ein impulsförmiges Phasenvoreilfehlersignal (PUP) erzeugt, das aus Spannungsimpulsen mit einer Breite entsprechend der Voreilung der Anstiegsflanke jedes periodischen Leseimpulses gegenüber einer Bezugsflanke des frequenzvariablen Signals besteht, und wobei die Phasenvergleichsschaltung ferner ein impulsförmiges Fehlersignal (FPUMP) erzeugt, dessen Amplitudenmittelwert dem Frequenzfehler des frequenzvariablen Signals (VFO) gegenüber dem Arbeitsfrequenzsignal (OSC) proportional ist;
   - einem frequenzvariablen Oszillator (3) zum Erzeugen des frequenzvariablen Signals (VFO) mit einer Frequenz, welcher der Spannung an einem Eingang des Oszillators proportional ist;
   **dadurch gekennzeichnet,** daß ferner vorgesehen sind:
   - eine Schaltungsanordnung (12, 14) zum Erzeugen eines impulsförmigen Phasennacheilfehlersignals (FF12) bestehend aus Spannungsimpulsen mit einer Breite praktisch gleich der Nacheilung der Vorderflanke jedes der periodischen Leseimpulse gegenüber einer Bezugsflanke des frequenzvariablen Signals;
   - ein integrierendes Filternetzwerk mit einem Schaltungspunkt (29), einem ersten Widerstand (4), dessen einer Anschluß mit jenem Schaltungspunkt (29) und dessen anderer Anschluß mit der Phasenvergleichsschaltung (1) verbunden ist und dem das Phasenvoreilfehlersignal (PUP) zugeführt wird, einem zweiten Widerstand (6), dessen einer Anschluß mit jenem Schaltungspunkt (29) und dessen anderer Anschluß ebenfalls mit der Phasenvergleichsschaltung (1) verbunden ist und dem das Frequenzfehlersignal (FPUMP) zugeführt wird, einem dritten Widerstand (5), dessen einer Anschluß mit jenem Schaltungspunkt (29) und dessen anderer Anschluß mit einer Schaltungsanordnung (16) verbunden ist, welche vom impulsförmigen Phasennacheilfehlersignal (FF12) derart gesteuert wird, daß sie den anderen Anschluß während der Dauer des Phasennacheilfehlersignals an Masse legt; einem ersten Kondensator (7), dessen eine Belegung mit jenem Schaltungspunkt (29) verbunden ist und dessen andere Belegung über ein erstes aus der Parallelschaltung eines Kompensationswiderstands (25) und eines Kompensationskondensators (22) bestehendes Kompensationsnetzwerk mit Masse verbunden ist;
   - eine Spannungsfolgeschaltung (15) hoher Eingangsimpedanz, deren Eingang mit jenem Schaltungspunkt (29) und deren Ausgang mit dem Eingang des frequenzvariablen Oszillators verbunden ist;
   - und dadurch, daß das frequenzvariable Signal (VFO) dem dritten Eingang der Phasenvergleichsschaltung (1) sowie einem Eingang der Schaltungsanordnung (12, 14) zugeleitet wird.

2. Phasenverriegelungsschaltkreis nach Anspruch 1, bei welchem der Oszillator (2, 11) einen Frequenzteiler (10) und einen Multiplexer (13) umfaßt, welcher von wenigstens einem Steuersignal (LFSEL) gesteuert wird und der Phasenvergleichsschaltung (1) selektiv eine von zwei Arbeitsfrequenzen zuleitet, und wobei das integrierende Netzwerk einen zweiten Kondensator (21) enthält, dessen eine Belegung mit jenem Schaltungspunkt (29) und dessen andere Belegung über ein zweites aus einem Kompensationswiderstand (26) und einem Kompensationskondensator (23) bestehendes Kompensationsnetzwerk mit Masse verbunden ist, wobei eine erste vom Steuersignal (LFSEL) gesteuerte logische Steuereinrichtung (17, 18, 30) abwechselnd exklusiv den ersten oder den zweiten Kondensator von Masse trennt und der frequenzvariable Oszillator (3) einen Frequenzteiler (40) sowie einen vom Steuersignal (LFSEL) gesteuerten Multiplexer (43) aufweist zur Erzeugung von wenigstens zwei frequenzvariablen Signalen, von denen eines die doppelte Frequenz hat wie das andere und wobei der Phasenvergleichsschaltung und der Schaltungsanordnung selektiv eines der beiden frequenzvariablen Signale zugeführt wird.

3.  Phasenverriegelungsschaltkreis nach Anspruch 2, bei welchem die Schaltungsanordnung (12, 14) einen von der Anstiegsflanke der periodischen Leseimpulse getriggerten Univibrator (14) zum Erzeugen von Impulsen aufweist, deren Dauer von einem externen Integriernetzwerk (24, 27, 32) mit wenigstens zwei Zeitkonstanten bestimmt wird, die gegenseitig exklusiv vom Steuersignal (LFSEL) auswählbar sind, sowie eine zweite Logikschaltung (12) aufweist, welche als Eingangssignale die vom Univibrator erzeugten Impulse und vom Ausgang des frequenzvariablen Oszillator (3) das frequenzvariable Signal (VFO) empfängt und das impulsförmige Phasennacheilfehlersignal (FF12) erzeugt.

4.  Phasenverriegelungsschaltkreis nach Anspruch 3, wobei das externe Integriernetzwerk (24, 27, 32) mit einem Spannungssignal (VV) gespeist wird, welches sich praktisch wie die Spannung am genannten Schaltungspunkt (29) ändert.

5.  Phasenverriegelungsschaltkreis nach Anspruch 3, wobei der frequenzvariable Oszillator (3) zur gegenseitig exklusiven Erzeugung von wenigstens zwei frequenzvariablen Signalen einen externen Kondensator (8) und einen externen Abgleichwiderstand (9) enthält, welche unabhängig von dem als Ausgangssignal des frequenzvariablen Oszillators ausgewählten frequenzvariablen Signal eine einzige Arbeitsfrequenz festlegen.

6.  Phasenverriegelungsschaltkreis nach Anspruch 5, **dadurch gekennzeichnet,** daß der frequenzvariable Oszillator zur Temperaturstabilisierung des Arbeitsbereichs einen PTC-Widerstand (28) aufweist.

FIG. 1

FIG. 2

FIG. 3

FIG. 4

13

FIG. 5

EP 0 274 591 B1

FIG. 6

FIG. 7

FIG. 8

RD

VFO

UNIV

FF 12

FIG. 9

PUP

33

37

39

38

36

ØE

VFO<Fo

34

35

VFO=Fo

VFO>Fo

PDOWN *

FIG. 10